# EUROPEAN PATENT APPLICATION

(11) **EP 2 741 580 A1**
(43) Date of publication of application: **11.06.2014**
(21) Application number: 13179589.0
(22) Date of filing: 07.08.2013
(51) Int. Cl.: H05B 33/08

(54) **Direct current power supply device and lighting apparatus**

(30) Priority: 07.12.2012 JP 2012268778
(71) Applicant: Toshiba Lighting & Technology Corporation, Yokosuka-shi Kanagawa 237-8510 (JP)
(72) Inventor: Terasaka, Hiroshi, Yokosuka-shi, Kanagawa 237-8510 (JP)
(74) Representative: Willquist, Sofia Ellinor

(57) **Abstract**

According to one embodiment, a direct-current power supply device and an LED lighting apparatus are provided in which arc discharge is more certainly detected and versatility can be improved. The direct-current power supply device includes a constant-current circuit, a voltage detection unit, a current detection unit and a control unit. The constant-current circuit is supplied with power by an external power supply and outputs a constant current to an LED. The voltage detection unit detects one of a load voltage and an electric quantity corresponding to the load voltage. The current detection unit detects one of a load current and an electric quantity corresponding to the load current. The control unit reduces or stops the output current from the constant-current circuit if a detected value of the voltage detection unit increases and a detected value of the current detection unit does not at least increase.

## Description

### FIELD

Embodiments described herein relate generally to a direct-current power supply device including a constant-current circuit to output a constant current to a load, and a lighting apparatus including the same.

### BACKGROUND

Hitherto, for example, an LED lighting apparatus is known in which a module including plural LEDs connected in series is detachably and attachably connected to a constant-current circuit of a direct-current power supply device and lighting is performed. There is a structure in which when arc discharge is generated in the circuit by defective contact or disconnection in a connection part of the circuit of the LED lighting device, especially in a connection part between the module and the direct-current power supply device, and when increase of output voltage of the constant-current circuit, that is, increase of load voltage is detected, the output current of the constant-current circuit is reduced to extinguish the arc discharge. Besides, there is a structure in which the maximum voltage of a direct-current power supply part as a power source of the constant-current circuit is regulated to be within a range where the arc discharge is not generated, and the arc discharge is prevented from being generated.

However, in the structure, there is a fear that even when the load voltage is increased by, for example, voltage fluctuation of the direct-current power supply part, a determination is erroneously made that the arc discharge is generated, and the output current of the constant-current circuit is reduced.

Besides, in the above structure, the voltage control range of the direct-current power supply part is limited, and versatility is decreased.

### BRIEF DESCRIPTION OF THE DRAWINGS

FIG. 1 is a block diagram showing a direct-current power supply device of an embodiment.
FIG. 2 is a block diagram showing a lighting apparatus including the direct-current power supply device.

### DETAILED DESCRIPTION

In general, according to one embodiment, a direct-current power supply device includes a constant-current circuit, a voltage detection unit, a current detection unit and a control unit. The constant-current circuit is supplied with power by an external power supply and outputs a constant current to a load. The voltage detection unit detects one of a load voltage and an electric quantity corresponding to the load voltage. The current detection unit detects one of a load current and an electric quantity corresponding to the load current. The control unit reduces or stops the output current from the constant-current circuit if a detected value of the voltage detection unit increases and a detected value of the current detection unit does not at least increase.

Hereinafter, a structure of an embodiment will be described with reference to the drawings.

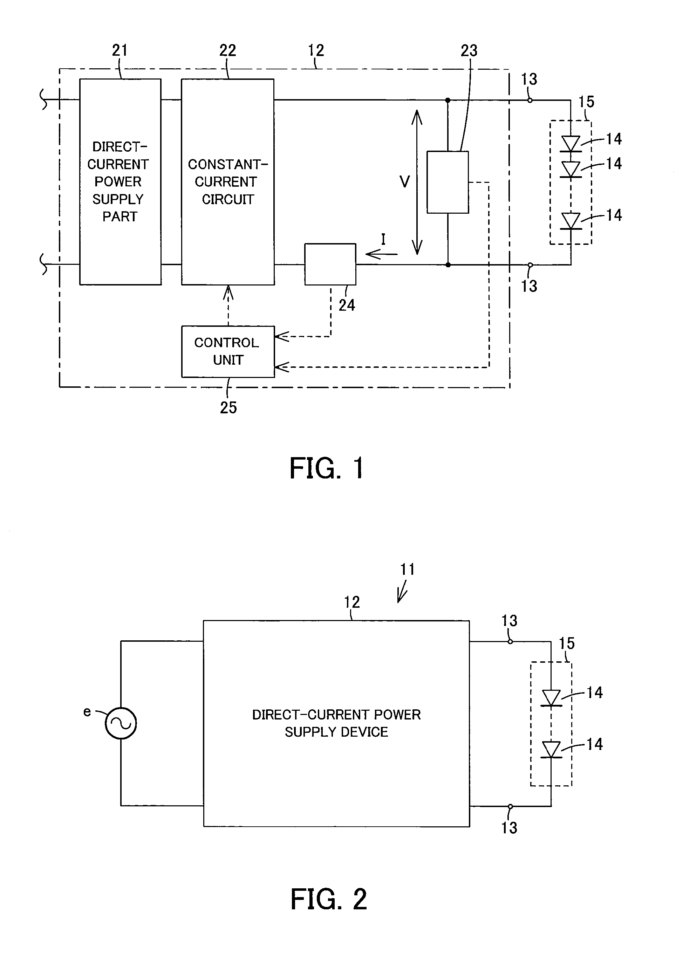

In FIG. 2, reference numeral 11 denotes an LED lighting apparatus as a lighting apparatus, and the LED lighting apparatus 11 includes a direct-current power supply device 12 electrically connected to an external power supply, for example, a commercial alternating-current power supply e, and a module 15 including a series circuit of LEDs 14, which are light-emitting elements as plural loads, electrically connected to the direct-current power supply device 12 through contacts 13 and 13. Incidentally, the module 15 may be detachable and attachable through the contacts 13 and 13. The LED lighting apparatus 11 is constructed such that constant current is supplied from the direct-current power supply device 12 to the LEDs 14 (the module 15) and the LEDs 14 are lit. Incidentally, the module 15 may be singly connected to the direct-current power supply device 12 or plural modules may be connected in parallel thereto.

As shown in FIG. 1 and FIG. 2, the direct-current power supply device 12 includes a direct-current power supply part 21, a constant-current circuit 22 operated by power supply from the direct-current power supply part 21, a voltage detection unit 23 to detect an output voltage from the constant-current circuit 22, that is, a load voltage V, a current detection unit 24 to detect an output current from the constant-current circuit 22, that is, a load current I, and a control unit 25 to control an operation of the constant-current circuit 22.

The direct-current power supply part 21 is constant voltage circuit which includes a circuit to (full-wave) rectify and smooth an AC voltage from, for example, the commercial alternating-current power supply e as the external power supply, a step-up/down circuit for suitably stepping up/down the voltage, and outputs a specified DC constant voltage.

The constant-current circuit 22 includes, for example, a chopper circuit, and outputs a DC constant current to the LEDs 14 (the module 15).

The voltage detection unit 23 includes an impedance element, such as a resistor, connected between, for example, both ends of the series circuit of the LEDs 14, that is, between the contacts 13 and 13 of the module 15, and can always output the detected load voltage V to the control unit 25. That is, the control unit 25 monitors the load voltage V through the voltage detection unit 23. Incidentally, the voltage detection unit 23 may directly detect the load voltage V, or may detect an electric quantity corresponding to the load voltage V. Accordingly, hereinafter, the load voltage V detected by the voltage detection unit 23, or the detected value of the voltage detection unit 23 represents the load voltage V or the electric quantity corresponding to the load voltage V.

The current detection unit 24 includes an impedance element, such as a resistor, connected between, for example, the constant-current circuit 22 and the LED 14 (the contact 13 of the module 15), and can always output the detected load current I to the control unit 25. That is, the control unit 25 monitors the load current I through the current detection unit 24. Incidentally, the current detection unit 24 may directly detect the load current I or may detect an electric quantity corresponding to the load current I. Accordingly, hereinafter, the load current I detected by the current detection unit 24 or the detected value of the current detection unit 24 represents the load current I or the electric quantity corresponding to the load current I.

The control unit 25 is, for example, a microcomputer, includes a not-shown storage unit (memory) and the like, and controls the output current from the constant-current circuit 22 into a specified constant current by performing PWM control of, for example, a switching element of the chopper circuit of the constant-current circuit 22. Further, the control unit 25 sequentially acquires the detected value of the voltage detection unit 23 and the detected value of the current detection unit 24 at a specified timing, such as every specified cycle of the AC voltage (AC current) of, for example, the commercial alternating-current power supply e, or every specified cycle of the voltage (current) obtained by rectifying the commercial power supply e, or every cycle (period) of not more than half of the cycle of the AC voltage (AC current) of the commercial alternating-current power supply e.

The control unit 25 controls the operation of the constant-current circuit 22 based on the load voltage V detected by the voltage detection unit 23 and the load current I detected by the current detection unit 24. Specifically, the control unit 25 determines that arc discharge is generated if the detected value of the voltage detection unit 23 increases and the detected value of the current detection unit 24 does not at least increase, that is, the value hardly changes or is decreased, and reduces the output current from the constant-current circuit 22. Incidentally, the reduction of the output current includes a reduction of the output current from the constant-current circuit 22 to 0, that is, stopping of the output from the constant-current circuit 22 (stopping of the operation of the constant-current circuit 22).

Such arc discharge is generated, for example, at the contact 13 when the module 15 is detached from the direct-current power supply device 12 or the module 15 is not certainly fixed to the direct-current power supply device 12, or is generated at each connection part by circuit disconnection, defective contact or the like. When the arc discharge is generated, since the arc discharge is electrically equivalent to an impedance component, the load voltage V is increased by the arc discharge generated between the constant-current circuit 22 and the module 15, while the load current I is hardly changed or is limited and decreased by the impedance component of the arc discharge. Accordingly, if the detected value of the voltage detection unit 23 increases, and the detected value of the current detection unit 24 does not at least increase, it can be determined that the arc discharge is generated.

Incidentally, the control unit 25 determines, a specified number of times, whether the detected value of the voltage detection unit 23 is changed and whether the detected value of the current detection unit 24 is changed, and when the determination that the arc discharge is generated is continued a specified consecutive number of times, or the ratio of the number of times of the determination that the arc discharge is generated is a specified value or higher, the control unit may reduce the output current from the constant-current circuit 22.

Besides, the control unit 25 previously stores, for example, a specified voltage threshold and a specified current threshold, and compares the voltage threshold and the current threshold with the detected value of the voltage detection unit 23 and the detected value of the current detection unit 24, and may determine the change (increase or decrease) of the detected value of the voltage detection unit 23 and the change (increase or decrease) of the detected value of the current detection unit 24. Alternatively, the control unit 25 stores the detected value of the voltage detection unit 23 and the detected value of the current detection unit 24 at every specified cycle of the AC voltage (AC current) of the commercial alternating-current power supply e or the voltage (current) obtained by rectifying the commercial alternating-current power supply e, and compares the stored values with new detected values, and may determine the change (increase or decrease) of the detected value of the voltage detection unit 23 and the change (increase or decrease) of the detected value of the current detection unit 24.

Further, in the state where when it is determined that the arc discharge is generated and the output current from the constant-current circuit 22 is reduced, if the load voltage V detected by the voltage detection unit 23 is a specified normal value (normal range), the control unit 25 determines that the arc discharge is extinguished, and restores (restarts) the output current from the constant-current circuit 22. Incidentally, a determination is made a specified number of times for the detected value of the voltage detection unit 23, and when the determination that the arc discharge is extinguished is continued a specified consecutive number of times, or the ratio of the number of times of the determination that the arc discharge is extinguished is a specified value or higher, this control may be performed. When the output current from the constant-current circuit 22 is restored, the operation of the constant-current circuit 22 may be restored by a normal activation (starting) sequence, or the operation of the constant-current circuit 22 may be restored by using a sequence different from this activation sequence.

On the other hand, in the state where it is determined that the arc discharge is generated and the output current from the constant-current circuit 22 is reduced, if the load voltage V detected by the voltage detection unit 23 is not the specified normal value (normal range) (the load voltage is an abnormal value (abnormal range)), the control unit 25 determines that the circuit is abnormal (arc discharge is not extinguished), and stops the constant-current circuit 22. At least, unless the LEDs 14 (the module 15) are once detached from the direct-current power supply device 12 and are again mounted, and unless power is again applied, the control unit 25 inhibits the output current from the constant-current circuit 22 from being restored. Incidentally, a determination is made a specified number of times for the detected value of the voltage detection unit 23, and when the determination that the circuit is abnormal is continued a specified consecutive number of times, or the ratio of the number of times of the determination that the circuit is abnormal is a specified value or higher, this control may be performed. Besides, when the determination is made that the circuit is abnormal, the control unit 25 further reduces the output current of the constant-current circuit 22, and then, may determine whether the arc discharge is extinguished or the circuit is abnormal by using the load voltage V detected by the voltage detection unit 23. The reduction of the output current of the constant-current circuit 22 and the determination may be performed an arbitrary number of times.

According to the embodiment described above, if the detected value of the voltage detection unit 23 increases, and the detected value of the current detection unit 24 does not at least increase (does not substantially change or decreases), the control unit 25 reduces or stops the output current from the constant-current circuit 22. Accordingly, for example, as compared with a case where generation of arc discharge is determined by detecting increase of load voltage through a voltage detection unit, the arc discharge can be more certainly detected, and an erroneous determination can be suppressed. Further, since the voltage range of the direct-current power supply part 21 is not required to be regulated, the voltage control range can be made wide, and the versatility is improved.

Besides, in the state where it is determined that the arc discharge is generated, and the output current from the constant-current circuit 22 is reduced, if the load voltage V detected by the voltage detection unit 23 is the specified normal value (normal range), the control unit 25 determines that the arc discharge is extinguished, and causes the output current from the constant-current circuit 22 to be restored. Accordingly, the extinction of the arc discharge is certainly detected, and when the extinction is detected, the LEDs 14 can be quickly lit again.

Further, in the state where it is determined that the arc discharge is generated, and the output current from the constant-current circuit 22 is reduced, if the load voltage V detected by the voltage detection unit 23 is not the specified normal value (normal range), the control unit 25 determines that the circuit is abnormal, and stops the constant-current circuit 22. At least, unless the LEDs 14 (the module 15) are detached from the direct-current power supply device 12 and are again mounted, and unless power is again applied, the control unit 25 inhibits the output current from the constant-current circuit 22 from being restored. Accordingly, the control unit can certainly prevent the LED lighting apparatus 11 from continuing the operation in the state where the abnormality occurs in the circuit.

Then, the LEDs 14 are lit by the direct-current power supply device 12, and consequently, the LEDs 14 can be stably lit while being protected.

Incidentally, in the embodiment, an arbitrary load other than the LED 14 can be used as the load.

Besides, an arbitrary light-emitting element other than the LED, for example, an organic EL can be used as the light-emitting element.

Further, although the direct-current power supply device 12 uses the commercial alternating-current power supply e as the external power supply, and includes the direct-current power supply part 21 to rectify and smooth the commercial alternating-current power supply e, a DC external power supply may be directly used without providing the direct-current power supply device.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A direct-current power supply device (12) comprising:
a constant-current circuit (22) which is supplied with power by an external power supply (e) and outputs a constant current to a load (14);
a voltage detection unit (23) to detect one of a load voltage and an electric quantity corresponding to the load voltage;
a current detection unit (24) to detect one of a load current and an electric quantity corresponding to the load current; and
a control unit (25) to reduce or stop the output current from the constant-current circuit (22) if a detected value of the voltage detection unit (23) increases and a detected value of the current detection unit (24) does not at least increase.

2. The device (12) according to claim 1, wherein in a state where the output current from the constant-current circuit (22) is reduced, if the detected value of the voltage detection unit (23) is within a specified normal range, the control unit (25) restores the output current from the constant-current circuit (22).

3. The device (12) according to claim 1 or 2, wherein in a state where the output current from the constant-current circuit (22) is reduced, if the detected value of the voltage detection unit (23) is not within a specified normal range, the control unit (25) stops the constant-current circuit (22), and inhibits the output current from the constant-current circuit (22) from being restored unless the load (14) is once detached and is again mounted and unless restarting is performed.

4. The device (12) according to any one of claims 1 to 3, wherein the external power supply (e) is a commercial alternating-current power supply.

5. A lighting apparatus (11) comprising:
a light-emitting element (14) as a load; and
a direct-current power supply device (12) according to any one of claims 1 to 4, which outputs a constant current to the light-emitting element (14).

6. The apparatus (11) according to claim 5, wherein the light-emitting element (14) includes a plurality of LED elements connected in series to each other.
